(19) Europäisches Patentamt
European Patent Office
Office européen des brevets

(11) **EP 3 667 915 A1**

(12) **DEMANDE DE BREVET EUROPEEN**

(43) Date de publication:
**17.06.2020 Bulletin 2020/25**

(51) Int Cl.:
*H03K 5/13* *(2014.01)*   *H03K 5/00* *(2006.01)*

(21) Numéro de dépôt: **19214959.9**

(22) Date de dépôt: **10.12.2019**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **11.12.2018 FR 1872691**

(71) Demandeur: **Commissariat à l'Energie Atomique
et aux Energies
Alternatives
75015 Paris (FR)**

(72) Inventeurs:
• **BILLIOT, Gérard**
  **38054 Grenoble Cedex 9 (FR)**
• **BADETS, Franck**
  **38054 Grenoble Cedex 9 (FR)**

(74) Mandataire: **Cabinet Beaumont
4, Place Robert Schuman
B.P. 1529
38025 Grenoble Cedex 1 (FR)**

(54) **CIRCUIT RETARDATEUR**

(57) La présente description concerne un circuit de génération d'un retard, comportant un élément capacitif (Cc) d'intégration d'un premier courant (I2) fourni par une première source de courant (2), dans lequel la première source de courant comporte un circuit (24) à capacités commutées (C0).

Fig 3

EP 3 667 915 A1

**Description**

Domaine technique

La présente description concerne de façon générale les circuits électroniques et, plus particulièrement, les circuits programmables de génération de retard asynchrones. La présente description concerne plus précisément les circuits basés sur des générateurs de rampe.

Technique antérieure

Dans de nombreuses applications, on souhaite disposer de retardateurs de signaux électroniques. Il peut s'agir, par exemple, de comparateurs de phase, de fonctions de synchronisation, de générateurs de signaux d'horloge, de circuits de transmission, etc. Le plus souvent, on souhaite également pouvoir programmer le retard, c'est-à-dire en ajuster la valeur. Par ailleurs, il est également généralement souhaitable de pouvoir garantir la relation entre une consigne fournie par l'application de la valeur du retard obtenu sur le signal traité par le retardateur.

Les fonctions de génération d'un retard programmable fournissent généralement une impulsion au bout d'un certain temps suivant un événement déclencheur. Ce temps définit la valeur du retard. La programmation du retard (consigne) peut prendre diverses formes analogiques ou numériques.

Les fonctions ou circuits à retard programmable peuvent se répartir en trois grandes catégories.

Une première catégorie concerne les solutions à base de compteurs numériques incrémentés au rythme d'un oscillateur. L'événement déclencheur est généralement une initialisation du compteur. L'impulsion de retard est déclenchée lorsque le compteur atteint un compte donné représentant la consigne.

Une deuxième catégorie concerne les solutions à base d'éléments retardateurs (le plus souvent des inverseurs logiques) montés en boucle à verrouillage de retard (DLL - Delay Locked Loop).

Une troisième catégorie concerne les solutions basées sur un générateur de rampe de tension à partir d'une charge de capacité. Dans ces solutions, une rampe de tension est obtenue par la charge d'une capacité à courant constant et l'impulsion de retard est générée lorsque la tension de la rampe atteint un seuil représentant la consigne.

La présente description concerne plus particulièrement cette troisième catégorie de retardateurs.

Le document US-A-2012/212265 décrit un circuit de génération d'un retard basé sur une source de courant à capacités commutées. Un inconvénient de la solution proposée par ce document est que le retard généré est sensible aux variations de température, de tension d'alimentation et de la vitesse de variation du signal à retarder.

Le document US-A-2018/0323696 décrit un circuit et un procédé de commande d'un convertisseur de puissance utilisant un circuit retardateur basé sur un générateur de rampe.

Le document US-A-2009/0268778 décrit un détecteur de température et son procédé d'utilisation.

Le document US-A-2010/0026542 décrit un circuit de génération adaptative de courant de polarisation pour circuit à capacités commutées.

Le document FR-A-2 975 246 décrit un dispositif de génération d'un signal en dents de scie.

Résumé de l'invention

Il existe un besoin d'amélioration des retardateurs électroniques en termes de plage de fonctionnement (plage de valeurs possibles du retard).

Il existe également un besoin d'amélioration des retardateurs électroniques en termes de résolution (écart entre deux valeurs consécutives du retard).

Il existe également un besoin d'amélioration des retardateurs électroniques en termes de fiabilité en cas de dérives des composants sous l'effet notamment de la température.

Il existe en outre un besoin d'amélioration des retardateurs électroniques en termes de stabilité à des variations de la tension d'alimentation.

Un mode de réalisation pallie tout ou partie des inconvénients des circuits retardateurs usuels.

Un mode de réalisation prévoit un circuit de génération d'un retard, comportant un élément capacitif d'intégration d'un premier courant fourni par une première source de courant, dans lequel la première source de courant comporte un circuit à capacités commutées.

Selon un mode de réalisation, le circuit comporte en outre un comparateur d'une première tension de charge dudit élément capacitif par rapport à une deuxième tension.

Selon un mode de réalisation, la deuxième tension est générée par une première impédance alimentée par une deuxième source de courant fournissant un deuxième courant proportionnel à un troisième courant, le troisième courant étant généré par une troisième source de courant comportant une deuxième impédance de même nature que la première impédance.

Selon un mode de réalisation, la deuxième source de courant est un convertisseur numérique-analogique.

Selon un mode de réalisation, une valeur numérique appliquée au convertisseur programme le retard.

Selon un mode de réalisation, la deuxième tension est référencée à un premier potentiel supérieur à un potentiel auquel est référencée la première tension.

Selon un mode de réalisation, la première source de courant comporte au moins un premier transistor MOS en série avec ledit circuit à capacité commutée, et un amplificateur monté en suiveur de commande dudit premier transistor à partir d'une première tension de référence.

Selon un mode de réalisation, la troisième source de courant comporte au moins un deuxième transistor MOS en série avec ladite deuxième impédance, et un amplificateur monté en suiveur de commande dudit deuxième transistor à partir d'une deuxième tension de référence.

Selon un mode de réalisation, la première tension de référence et la deuxième tension de référence ont un même signe de coefficient de température.

Selon un mode de réalisation, la première tension de référence et la deuxième tension de référence sont égales.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une représentation très schématique d'un exemple de retardateur à rampe 1 du type auquel s'appliquent des modes de réalisation qui vont être décrits ;

la figure 2 illustre, par des chronogrammes Fig 2A, Fig 2B et Fig 2C, le fonctionnement d'un retardateur à rampe du type de celui décrit en relation avec la figure 1 ;

la figure 3 représente, de façon très schématique et fonctionnelle, un mode de réalisation d'un circuit retardateur ;

la figure 4 est une représentation schématique et sous forme de blocs d'un mode de réalisation d'un circuit retardateur programmable numériquement ;

la figure 5 représente, de façon schématique, un mode de réalisation d'un convertisseur numérique-analogique et d'une source de courant ;

la figure 6 illustre, par des chronogrammes Fig 6A et Fig 6B, le démarrage d'une rampe de tension du circuit retardateur ;

la figure 7 représente, de façon très schématique et sous forme de blocs, un autre mode de réalisation d'un circuit retardateur ;

la figure 8 est une représentation partielle d'un exemple de structure interne d'un mode de réalisation d'un convertisseur numérique-analogique ;

la figure 9 représente, de façon schématique, un mode de réalisation d'une source de courant ;

la figure 10 représente, de façon schématique, un autre mode de réalisation d'une source de courant ;

la figure 11 représente, de façon schématique et fonctionnelle, un autre mode de réalisation d'une source de courant ;

la figure 12 représente, de façon schématique et fonctionnelle, encore un autre mode de réalisation d'une source de courant ;

la figure 13 représente, de façon très schématique, un schéma de principe d'un circuit retardateur à rampe ;

la figure 14 représente, de façon schématique, un mode de réalisation d'un circuit retardateur tel que schématisé en figure 13 ; et

la figure 15 illustre, par des chronogrammes, un exemple de signaux de commande des circuits retardateurs des figures 13 et 14.

Description des modes de réalisation

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la destination des retards générés n'a pas été détaillée, les modes de réalisation étant compatibles avec les destinations usuelles de signaux retardés qui dépendent de l'application, les modes de réalisation décrits étant en particulier compatibles avec les applications usuelles de retardateurs. De plus, la génération des signaux ou événements déclencheurs des retards générés par les circuits retardateurs des modes de réalisation décrits n'a pas été détaillée, les modes de réalisation décrits étant compatibles avec les techniques usuelles de génération des signaux déclencheurs qui dépendent de l'application.

Sauf précision contraire, lorsque l'on fait référence à deux éléments connectés entre eux, cela signifie directement connectés sans élément intermédiaire autre que des conducteurs, et lorsque l'on fait référence à deux éléments reliés (coupled) entre eux, cela signifie que ces deux éléments peuvent être directement reliés (connectés) ou être reliés par l'intermédiaire d'un ou plusieurs autres éléments.

Dans la description qui suit, lorsque l'on fait référence aux termes "approximativement", "environ" et "de l'ordre de", cela signifie à 10 % près, de préférence à 5 % près.

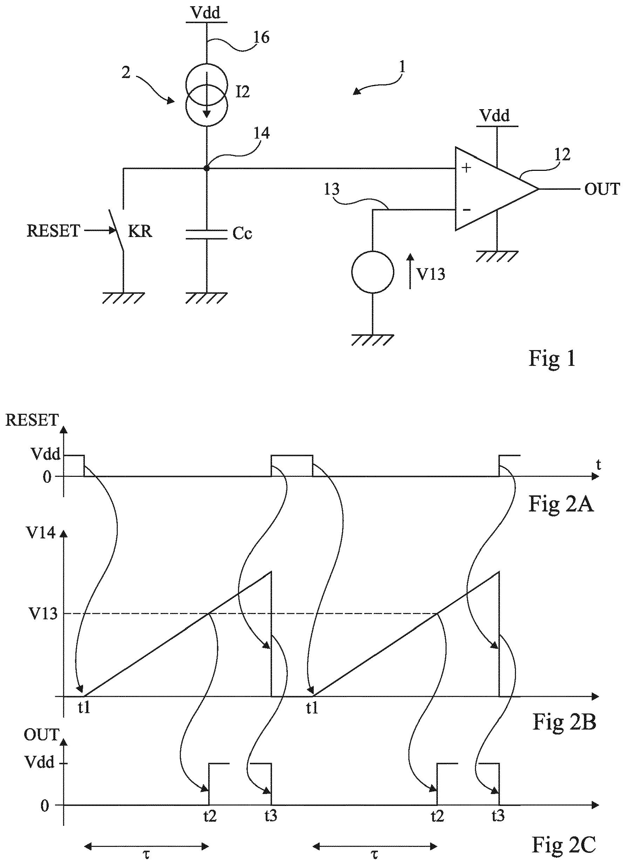

La figure 1 est une représentation très schématique d'un exemple de retardateur à rampe du type auquel s'appliquent des modes de réalisation qui vont être décrits.

Le circuit comporte un comparateur 12 dont une entrée 13 (par exemple inverseuse (-)) reçoit une tension de référence ou de consigne V13 et dont l'autre entrée 14 (par exemple non-inverseuse (+)) est reliée, de préférence connectée, à une première électrode d'un condensateur Cc dont l'autre électrode est reliée, de préférence connectée, à la masse. Le condensateur Cc est destiné à être chargé par une source 2 de courant I2 constant alimentée par une tension continue Vdd. La source de courant 2 relie une borne 16 d'application de la tension Vdd au noeud 14. Par ailleurs, le noeud 14 est relié à la masse par un commutateur KR de réinitialisation (signal RESET). Le commutateur KR est en parallèle avec le condensateur Cc et permet de le décharger à chaque fermeture de l'interrupteur KR. En d'autres termes, une ouverture de l'interrupteur KR constitue le déclencheur de la temporisation ou l'initialisation du retard. Après chaque ouverture de l'interrupteur KR, le potentiel du noeud 14 croît sous l'effet de la charge du condensateur Cc par le courant I2 fourni par la source 2. Dès que le potentiel atteint le seuil correspondant à la tension V13, la sortie OUT du comparateur bascule.

Les figures 2A, 2B et 2C sont des chronogrammes illustrant le fonctionnement d'un retardateur à rampe du type de celui décrit en relation avec la figure 1.

La figure 2A illustre un exemple d'allure du signal RESET. La figure 2B illustre un exemple correspondant d'évolution de la tension V14 aux bornes du condensateur Cc. La figure 2C illustre l'allure correspondante du signal OUT représentatif du retard généré. Les signaux RESET et OUT sont des signaux en tout ou rien (0 ou 1) tandis que le signal V14 est une rampe de tension.

A chaque instant t1 où l'interrupteur K est ouvert (figure 2A), un cycle de charge du condensateur Cc par le biais de la source de courant 2 commence. La tension V14 (figure 2B) commence à croître et, quand (instant t2) cette tension V14 atteint le seuil V13, la sortie OUT (figure 2C) du comparateur 12 bascule (dans cet exemple, vers l'état haut). La tension V14 continue à croître après l'instant t2, le cas échéant jusqu'à saturation, tant que la décharge du condensateur Cc n'est pas provoquée par la fermeture de l'interrupteur KR. Dès l'instant (t3) où le signal RESET repasse (arbitrairement) à l'état haut pour fermer l'interrupteur KR, le condensateur Cc est déchargé, et l'on peut recommencer un nouveau cycle.

Les niveaux haut et bas du signal OUT sont liés à la tension d'alimentation du comparateur 12 et sont arbitrairement notés comme étant Vdd et zéro (la masse) en négligeant notamment les chutes de tension dans les transistors à l'état passant du comparateur 12. De même, on suppose arbitrairement un signal RESET dont les états haut et bas sont respectivement Vdd et la masse.

Le retard $\tau$ (écart entre les instants t1 et t2) peut être programmé en contrôlant la pente de la rampe, c'est-à-dire le courant de charge ou la capacité du condensateur Cc, la tension de référence V13 du comparateur 12, ou la charge initiale du condensateur Cc.

Une solution analogique de génération de rampe telle qu'illustrée par la figure 1 est souvent préférée aux solutions purement numériques des deux autres catégories (à compteur ou à éléments retardateurs logiques) pour sa linéarité. En effet, à condition que la charge du condensateur Cc s'effectue bien sous courant constant, la rampe analogique présentée en entrée non-inverseuse 13 du comparateur 12 est bien linéaire.

Toutefois, un tel retardateur est souvent sensible à la température de fonctionnement. En particulier, un échauffement va influer sur la valeur du condensateur Cc et, dans un retardateur usuel, engendrer une dérive de la valeur du retard $\tau$ sous l'effet de la température. D'autre part, le courant de charge est lui-même sensible à la température.

Un tel retardateur est en outre sensible aux variations de tension d'alimentation du circuit.

Selon un aspect de la présente description, on cherche à améliorer la stabilité en température et en tension du retard généré.

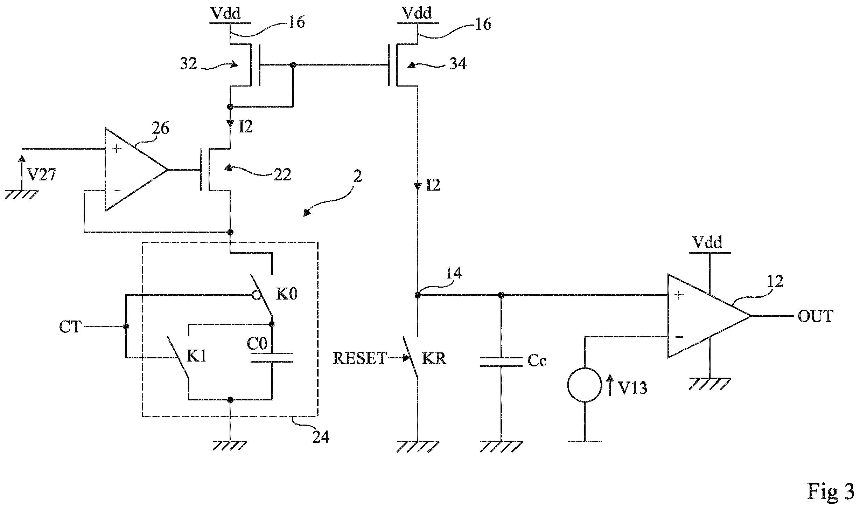

La figure 3 représente, de façon très schématique et fonctionnelle, un mode de réalisation d'un circuit retardateur selon cet aspect.

Selon un mode de réalisation, on prévoit de générer le courant I2 par un circuit à capacités commutées. Ainsi, la charge servant à générer le courant constant I2 est de même nature que la capacité Cc de génération de la rampe, et leurs contributions respectives, en termes de variation en fonction de la température et de la tension d'alimentation du circuit, se compensent.

La source de courant 2 est, dans l'exemple de la figure 3, basée sur un transistor MOS 22 en série avec un circuit 24 à capacités commutées. Le transistor 22 est commandé par un montage suiveur comportant un amplificateur opérationnel 26 dont une entrée non-inverseuse (+) reçoit une tension constante de référence V27 et dont une entrée inverseuse (-) est connectée entre le transistor 22 et le circuit 24. Par exemple, le drain du transistor 22 est relié à la borne 16 d'application de la tension d'alimentation Vdd et sa source est reliée, de préférence connectée, à une première borne du circuit 24 dont l'autre borne est reliée, de préférence connectée, à la masse. Le circuit 24 voit donc la tension V27 sur sa borne côté transistor 22.

Le circuit 24 comporte, par exemple, un élément capacitif C0 en série avec un commutateur K0 et en parallèle avec un commutateur K1. Les commutateurs K0 et K1 sont commandés alternativement (en opposition). En figure 3, on a illustré une commande des commutateurs K0 et K1 par un même signal périodique CT de fréquence f24, et une inversion de la commande du commutateur K0. De façon usuelle, selon la fréquence de commutation des commutateurs K0 et K1, le circuit 24 est équivalent à une charge résistive.

Un montage à miroir de courant sert à recopier le courant circulant dans la branche du transistor 22 sur le noeud 14 auquel est connecté l'élément capacitif Cc. Un tel montage à miroir de courant est en lui-même usuel. Un transistor 32 (par exemple MOS) relie, de préférence connecte, le transistor 22 (son drain) à la borne 16 d'application de la tension Vdd. La grille et le drain du transistor 32 sont interconnectés. Un transistor 34, de même type que le transistor 32, est monté en miroir sur le transistor 32 avec sa source reliée, de préférence connectée, à la borne 16. La grille du transistor 34 est reliée, de préférence connectée, à la grille du transistor 32 et son drain est relié, de préférence connecté, au noeud 14. Avec des transistors 32 et 34 ayant des rapports de surface identiques, le courant circulant dans le transistor 34, donc injecté sur le noeud 14, est égal au courant I2 circulant dans le transistor 22.

Le courant I2, fourni par la source de courant 2, est directement proportionnel au produit de la valeur de l'élément capacitif C0 par la tension V27 et par la fréquence f24 du signal CT. Le courant I2 peut s'écrire :

$$I2 = A \times C0 \times V27 \times f24 \qquad \text{(équation 1)}$$

où A désigne une constante.

Or, la tension V14 du noeud 14 peut s'écrire :

$$V14 = \frac{I2 \times t}{Cc} \qquad \text{(équation 2)}$$

où t désigne le temps (depuis le début de charge du condensateur Cc).

Ainsi, la tension V14 peut également s'écrire :

$$V14 = A \times V27 \times \frac{C0}{Cc} \times f24 \times t \qquad \text{(équation 3)}$$

Par conséquent, les dérives des éléments capacitifs C0 et Cc, lors de variations de température et de tension d'alimentation, ont des effets inverses, ce qui permet d'améliorer la stabilité en température et en tension.

Selon un mode de réalisation préféré, on prévoit de diminuer encore les effets de variations de température et de tension en agissant sur la génération de la tension V13 (figure 1) de consigne du retard.

Dans un retardateur programmable à rampe de tension, la programmation est généralement numérique, c'est-à-dire que la valeur du retard est déterminée (programmée) par un mot numérique dont la valeur conditionne la valeur de la tension V13.

Ce mot numérique est converti en signal analogique (en courant) par un convertisseur numérique-analogique, puis appliqué à une résistance de conversion courant-tension pour générer la tension V13.

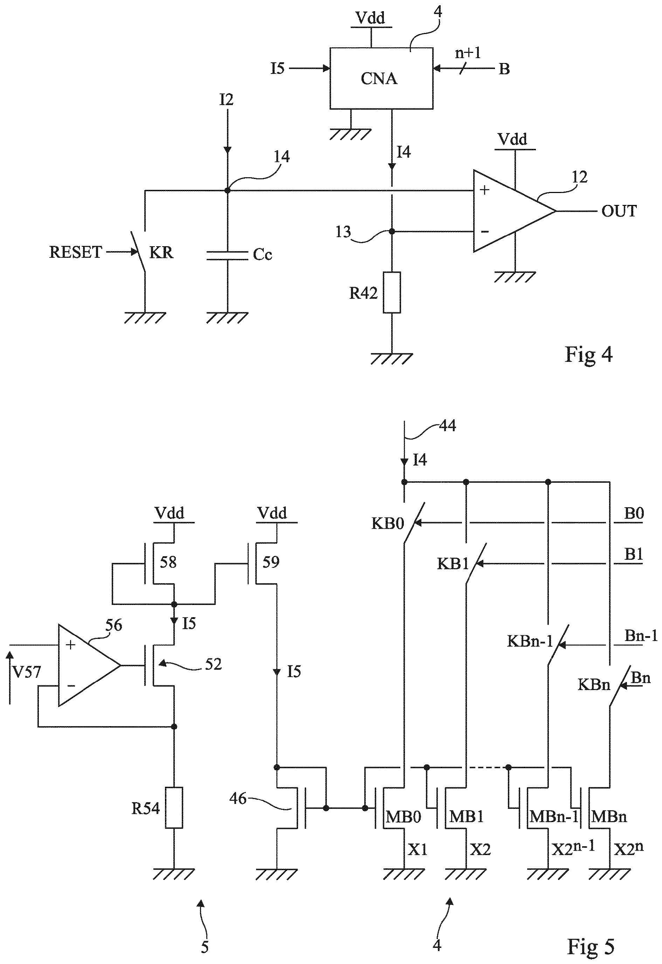

La figure 4 est une représentation schématique et sous forme de blocs d'un mode de réalisation d'un circuit retardateur programmable numériquement.

Selon ce mode de réalisation, le noeud 13, correspondant à l'entrée inverseuse (-) du comparateur 12 est relié, de préférence connecté, à une première borne d'une résistance R42 dont l'autre borne est reliée, de préférence connectée, à la masse. Un convertisseur numérique-analogique 4 (CNA) convertit un mot binaire B de n+1 (par exemple compris entre 8 et 16) bits B0, ..., Bn en un courant I4. La sortie du convertisseur 4, fournissant le courant I4, est reliée, de préférence connectée, au noeud 13. Le convertisseur 4 est alimenté par la tension Vdd et utilise un courant de référence I5 pour générer le courant I4.

Selon ce mode de réalisation, on prévoit de générer le courant I5 à partir d'une résistance afin que les effets de variations de température et de tension soient de même nature sur la résistance R42 et sur la résistance de la source de courant I4 et se compensent.

La figure 5 représente, de façon schématique, un mode de réalisation d'un convertisseur numérique-analogique 4 et d'une source 5 de courant I5.

Comme pour la génération du courant I2, on préfère généralement générer le courant I4 du convertisseur par rapport à une référence à la masse et effectuer ensuite une recopie de ce courant pour l'injecter dans la résistance R42. La figure 5 représente une telle réalisation. Pour simplifier, la recopie vers la résistance R42 n'est pas illustrée mais est en elle-même usuelle (voir figure 3).

Le courant I4 correspond à la somme des courants dans n+1 branches en parallèle du convertisseur 4 qui sont individuellement commandées par l'un des bits Bi (i compris entre 0 et n) du mot B. Chaque branche comporte, entre une borne 44 tirant un courant I4 et la masse, un commutateur KB0, KB1, ..., KBn-1, KBn, et un transistor MOS MB0, MB1, ..., MBn-1, MBn reliés en série. Les transistors MBi sont montés en miroir de courant sur un transistor 46 dans lequel circule le courant I5 fourni par la source 5 de courant constant. Ainsi, le drain et la grille du transistor 46 sont interconnectés et sa source est reliée, de préférence connectée, à la masse. Les grilles des transistors MBi sont connectées à la grille du transistor 46. Par ailleurs, les rapports de surface des transistors MBi doublent avec le rang i. En d'autres termes, en supposant un transistor MB0 de rapport de surface normalisée 1 ($2^0$), le transistor MB1 a un rapport de surface 2 (i.e. $2^1$), un transistor MBi a un rapport de surface $2^i$, le transistor MBn-1 a un rapport de surface $2^{n-1}$ et le transistor MBn a un rapport de surface $2^n$. Ainsi, le courant I4 peut s'écrire :

$$I4 \ = I5 \times \sum_{i=0}^{n}(Bi \times 2^i) \qquad \text{(équation 4)}$$

La source de courant 5 est, dans l'exemple de la figure 5, basée sur un transistor MOS 52 en série avec une résistance R54. Le transistor 52 est commandé par un montage suiveur comportant un amplificateur opérationnel 56 dont une entrée non-inverseuse (+) reçoit une tension constante de référence V57 et dont une entrée inverseuse (-) est connectée entre le transistor 52 et la résistance R54. Le courant I5 traversant le transistor 52 est recopié par un montage à miroir de courant sur le transistor 46. Par exemple, un transistor 58 (par exemple MOS) relie, de préférence connecte, le transistor 52 (sa source) à la borne 16 d'application de la tension Vdd. Un transistor 59, de même type que le transistor 58, est monté en miroir sur le transistor 58 avec sa source reliée, de préférence connectée, à la borne 16, sa grille reliée, de préférence connectée, à la grille du transistor 58 et son drain relié, de préférence connecté, au drain du transistor 46. Avec des transistors 58 et 59 ayant des rapports de surfaces identiques, le courant circulant dans le transistor 59, donc dans le transistor 46, est égal au courant I5 circulant dans le transistor 52.

Pour simplifier, on n'a pas représenté le montage à base de miroir de courant (de composition similaire au montage à base des transistors 58 et 59) permettant de transformer le courant I4 illustré en figure 5 en le courant I4 illustré en figure 4. De tels montages de conversion d'un courant extrait en un courant fourni, ou inversement, à base de miroirs de courant à transistors MOS sont usuels.

Un montage tel qu'illustré par les figures 4 et 5 permet de compenser d'éventuelles variations de température. En effet, le courant I5 peut, en première approximation, s'écrire :

$$I5 \ = \frac{V57}{R54} \qquad \text{(équation 5)}$$

et le courant I4 peut donc s'écrire :

$$I4 \ = \frac{V57}{R54} \times \sum_{i=0}^{n}(Bi \times 2^i) \qquad \text{(équation 6)}$$

Or, la tension V13 définissant la valeur de consigne ou de référence du retardateur vaut :

$$V13 = R42 \times I4 \qquad \text{(équation 7)}$$

Par conséquent, cette tension de consigne V13 peut s'écrire :

$$V13 = \frac{R42 \times V57}{R54} \times \sum_{i=0}^{n}(Bi \times 2^i) \qquad \text{(équation 8)}$$

On voit donc qu'avec des résistances R42 et R54 de même type ayant des coefficients de variation en température de même signe et de même ordre de grandeur, de préférence de même valeur, leurs évolutions respectives en fonction de la température auront des effets inverses sur la tension V13 et seront donc compensées. Il en est de même pour leurs dérives éventuelles sous l'effet de variation de la tension d'alimentation.

En fonctionnement, au moment où le comparateur 12 bascule, c'est-à-dire au moment où la rampe de tension atteint la valeur V13, on a :

$$V13 = V14 \ . \qquad \text{(équation 9)}$$

Soit (équation 10) :

$$\frac{R42 \times V57}{R54} \times \sum_{i=0}^{n}(Bi \times 2^i) = A \times V27 \times \frac{C0}{Cc} \times f24 \times \tau$$

L'équation ci-dessus peut également s'écrire (équation 11):

$$\tau = \frac{V57}{V27} \times \frac{R42}{R54} \times \frac{Cc}{C0} \times \frac{1}{A \times f24} \times \sum_{i=0}^{n}(Bi \times 2^i) \ .$$

De façon avantageuse, on peut prévoir des tensions V27 et V57 ayant des coefficients de variation de même signe en fonction de la température et de la tension d'alimentation. Ainsi, on réduit encore l'impact de la température sur le retard généré.

L'équation 11 ci-dessus montre en effet que, pour obtenir une stabilité en température et en tension d'alimentation (rendre le retard généré insensible aux variations de température et de tension d'alimentation), il suffit que les rapports V57/V27, R42/R45 et Cc/C0 soient chacun insensible à de telles variations. En d'autres termes, on fait en sorte qu'en cas de variations de température ou de tension d'alimentation du circuit :

les tensions V57 et V27 varient de la même manière (dans le même sens et avec la même amplitude de variation) ;

les résistances R52 et R54 varient de la même manière (dans le même sens et avec la même amplitude de variation) ; et

les capacités Cc et C0 varient de la même manière (dans le même sens et avec la même amplitude de variation).

Afin d'obtenir une variation similaire des tensions V27 et V57, de sorte que leur rapport reste constant en cas de variation de température ou de tension d'alimentation, on prévoit de générer ces deux tensions à partir de circuits de même structure, de préférence à partir d'un même circuit. En outre, dans le cas où les tensions V27 et V57 sont de valeurs différentes, on peut utiliser un circuit de génération d'une première tension de référence et l'autre des tensions de référence est obtenue en utilisant un diviseur de tension à partir de la première tension générée.

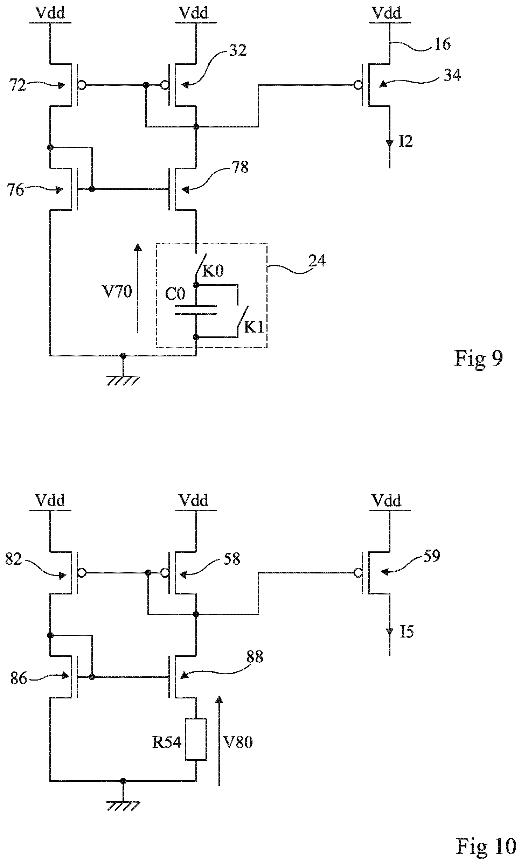

On notera qu'il n'est pas nécessaire que les tensions V27 et V57 soient égales. Il suffit, en effet, que leur rapport soit insensible aux variations de température et de tension d'alimentation. Par exemple, on peut prévoir d'utiliser, comme dans les modes de réalisation représentés, un circuit à source de courant exploitant une tension de consigne (V27 ou V57) fournie par un circuit de génération de tension de référence. Selon un autre exemple qui sera détaillé par la suite en relation avec les figures 9 et 10, on utilise une source de courant sans référence de tension externe mais dont, par construction, une charge (résistance ou capacité commutée) du montage à miroir de courant est polarisée par la structure.

Selon un mode de réalisation particulier, les tensions V27 et V57 sont identiques (égales) afin que leurs valeurs respectives soient de même contribution. Ainsi, le retard $\tau$ peut s'exprimer :

$$\tau = \frac{R42}{R54} \times \frac{Cc}{C0} \times \frac{1}{A \times f24} \times \sum_{i=0}^{n}(Bi \times 2^i) \qquad \text{(équation 12)}$$

ou encore :

$$\tau = cst \times \sum_{i=0}^{n}(Bi \times 2^i) \qquad \text{(équation 13)}$$

où cst représente une constante liée au circuit, et stable en température.

Selon une variante de réalisation, les éléments résistifs R42 et R54 sont réalisés sous la forme de capacités commutées. Afin de respecter la compensation de la variation en température et en tension sur la tension V13, on réalisera alors les deux éléments R42 et R54 sous forme de capacités commutées et non un seul des deux.

Plus généralement, les composants (impédances) intervenant dans la génération du courant I5 et de la tension V13 sont de même nature, de préférence passifs.

Afin de garantir la stabilité des rapports V57/V27 et R42/R54, on fait en sorte que la tension asservie aux bornes du circuit 24 à capacités commutées à la tension V27 et la tension de référence V13 du comparateur 12 présentent des variations similaires en cas de variations de température ou de tension d'alimentation. Ainsi, les éventuelles variations, sous l'effet de la température ou de la tension d'alimentation, des tensions V13 et V27 comparées par le comparateur 12 sont similaires.

Par ailleurs, afin d'améliorer encore la stabilité, le comparateur 12 est, tel que représenté aux figures, réalisé sous la forme d'un amplificateur opérationnel monté en comparateur (ou amplificateur différentiel) à deux entrées (l'une recevant la tension de référence V13, l'autre recevant la tension V14). Un avantage est alors que le décalage (offset) de comparaison est alors moins sensible à des variations de température et de tension que ne le serait un comparateur réalisé à partir de montages inverseurs. En outre, il existe différentes techniques de réalisation d'un tel comparateur qui permette de rendre le décalage (offset) du comparateur quasi insensible aux variations de température et de tension.

Selon un mode de réalisation préféré, on prévoit en outre de définir la plage de programmation du retardateur dans une portion linéaire de la rampe. En effet, les inventeurs ont constaté qu'au voisinage de l'instant t1 (figures 2A à 2C), la pente de la tension V13 n'est pas réellement linéaire.

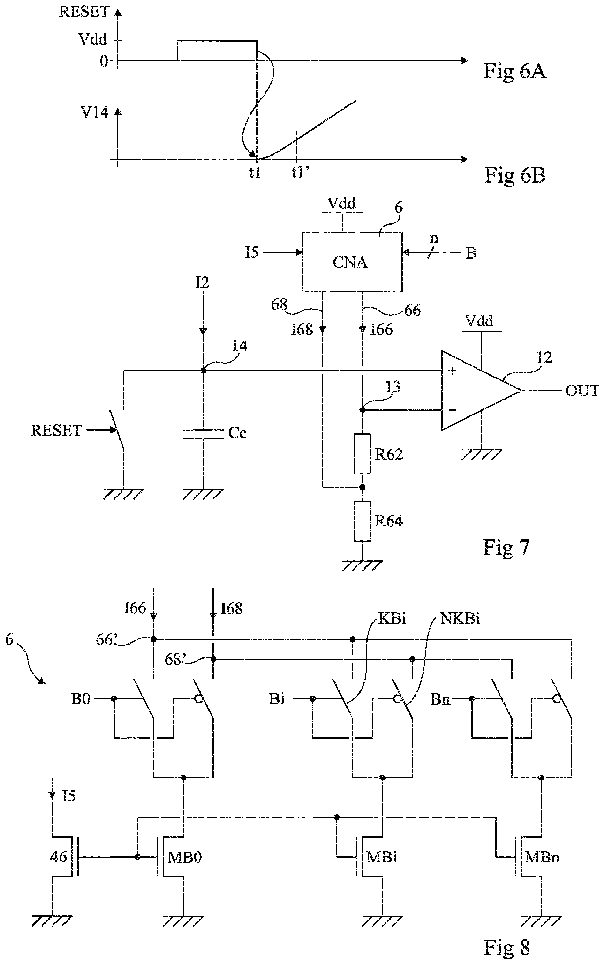

Les figures 6A et 6B illustrent, par des chronogrammes, le démarrage d'une rampe de tension du circuit retardateur.

Ces figures sont partielles et représentent, respectivement, un exemple d'allure du signal RESET et l'allure de la tension V14 sous l'effet de la charge du condensateur Cc.

On constate qu'au début de chaque cycle de charge, la pente de la rampe de tension V14 n'est pas linéaire mais ne le devient qu'après un intervalle de temps qui dépend de la constitution du circuit et du condensateur Cc. Ainsi, la pente ne devient linéaire qu'à partir d'un instant t1'.

La figure 7 représente, de façon très schématique et sous forme de blocs, un mode de réalisation d'un circuit retardateur, évitant cette zone non-linéaire.

Selon ce mode de réalisation, on décale la référence de la tension V13 de façon que, quelle que soit la valeur du mot B, la valeur du retard soit dans la plage de variation linéaire de la rampe de tension.

L'entrée de référence (entrée inverseuse (-)) du comparateur 12 est reliée, de préférence connectée, à la masse par une association en série de deux résistances R62 et R64. Un convertisseur numérique-analogique 6 (CNA) comporte deux sorties 66 et 68 de courant respectivement reliées, de préférence connectées, au nœud 13 et au point milieu de l'association en série des résistances R62 et R64. De plus, la somme des courants I66 et I68, fournis par les deux sorties 66 et 68, est égale au courant de référence I4 (figure 4) dont la valeur est indépendante du mot de programmation B. En fait, la constitution du convertisseur fait que chaque branche contribue, en fonction de l'état du bit Bi, soit au courant I66, soit au courant I68.

La figure 8 est une représentation partielle d'un exemple de structure interne d'un mode de réalisation d'un convertisseur numérique-analogique 6.

La structure est similaire à celle représentée en figure 5, à ceci près que chaque branche i comporte deux interrupteurs KBi et NKBi ayant une borne commune reliée, de préférence connectée, à la source du transistor MBi, et l'autre borne respectivement reliée, de préférence connectée, à une borne 66' ou 68', tirant respectivement le courant I66 ou I68. Comme pour la figure 5, on a simplifié la figure en ne représentant pas les miroirs de courant permettant en fait de recopier les courants I66 et I68 sur les sorties 66 et 68 (figure 7). Les interrupteurs KBi et NKBi de même rang sont commandés par le même bit Bi mais de façon inversée, c'est-à-dire que, lorsque le bit Bi est à l'état 1, l'interrupteur KBi est fermé et l'interrupteur NKBi est ouvert, et inversement.

Avec une telle réalisation, le courant I66 peut s'écrire :

$$I66 = I5 \times \sum_{i=0}^{n}(Bi \times 2^i) \qquad \text{(équation 14)}$$

et le courant I68 peut s'écrire :

$$I68 = I5 \times (1 - \sum_{i=0}^{n}(Bi \times 2^i)) \qquad \text{(équation 15)}$$

Or, la tension V13 peut s'écrire :

$$V13 = V62 + V64 \qquad \text{(équation 16)}$$

où V62 et V64 représentent les chutes de tension dans les résistances respectives R62 et R64.

Les tensions V62 et V64 peuvent s'écrire :

$$V62 = I66 \times R62 = R62 \times I5 \times \sum_{i=0}^{n}(Bi \times 2^i) \qquad \text{(équation 17)}$$

et

$$V64 = (I66 + I68) \times R64 = R64 \times I5 \qquad \text{(équation 18)}$$

La tension V13 peut donc s'écrire :

$$V13 = I5 \times (R64 + R62 \times \sum_{i=0}^{n}(Bi \times 2^i)) \qquad \text{(équation 19)}$$

En reportant la valeur (V57/R54) du courant I5 dans l'expression ci-dessus, on obtient :

$$V13 = \frac{V57}{R54} \times (R62 \times \sum_{i=0}^{n}(Bi \times 2^i) + R64) \qquad \text{(équation 20)}$$

ou

$$V13 = \frac{V57}{R54} \times R64 + \frac{V57}{R54} \times R62 \times \sum_{i=0}^{n}(Bi \times 2^i) \qquad \text{(équation 21)}$$

Le premier terme

$$\frac{V57}{R54} \times R64 \qquad \text{(équation 22)}$$

de l'équation ci-dessus définit l'intervalle de temps t1'-t1 (figure 6B) qui correspond à un retard minimal pour lequel on considère que le comportement du retardateur n'est pas linéaire.

La figure 9 représente, de façon schématique, un mode de réalisation d'une source de courant n'utilisant pas de référence de tension externe.

Le mode de réalisation de la figure 9 représente un exemple de circuit de génération du courant I2.

Par rapport au mode de réalisation de la figure 3, on retrouve le transistor 34 fournissant le courant I2 et monté en miroir de courant sur un transistor 32 d'une (première) branche comportant, entre autres, le circuit 24 à capacité commutée C0. Dans le mode de réalisation de la figure 9, le transistor 32 est également monté en miroir avec un transistor 72 d'une deuxième branche comportant, en série entre la borne 16 et la masse, le transistor 72 et un transistor 76. Le transistor 76 est par ailleurs monté en miroir sur un transistor 78 intercalé en série entre le transistor 32 et le circuit 24 dans la première branche. De façon connue, les géométries (W/L) des transistors 78 et 76 sont différentes (W/L du transistor 78 supérieure au W/L du transistor 76) de façon à déséquilibrer les tensions grille-source des transistors 76 et 78 et garantir qu'un courant circule dans le circuit 24 et permettre ainsi, par construction, la génération du courant I2. On peut considérer que la tension aux bornes du circuit 24 à capacité commutée est, par construction du double miroir de courant rebouclé, asservie à une tension de référence V70.

La figure 10 représente, de façon schématique, un autre mode de réalisation d'une source de courant.

Le mode de réalisation de la figure 10 représente un exemple de circuit de génération du courant I5.

Par rapport au mode de réalisation de la figure 5, on retrouve le transistor 59 fournissant le courant I5 et monté en miroir de courant sur un transistor 58 d'une (première) branche comportant, entre autres, la résistance R54. Dans le mode de réalisation de la figure 10, de façon similaire à la réalisation de la figure 9, le transistor 58 est également monté en miroir avec un transistor 82 d'une deuxième branche comportant, en série entre la borne 16 et la masse, le transistor 82 et un transistor 86. Le transistor 86 est par ailleurs monté en miroir sur un transistor 88 intercalé en série entre le transistor 58 et la résistance R54 dans la première branche. De même, les géométries des transistors 88 et 86 sont différentes de façon à déséquilibrer les tensions grille-source des transistors 86 et 88 et garantir qu'un courant circule dans la résistance R54 et permettre ainsi, par construction, la génération du courant I5. On peut considérer que la tension aux bornes de la résistance R54 est, par construction du double miroir de courant rebouclé, asservie à une tension de référence V80.

En utilisant des montages différentiels tels que représentés aux figures 9 et 10 pour la génération des courants I2 et I5, l'équation 11, décrite plus haut en référence aux figures 3 et 5, peut s'écrire (équation 23) :

$$\tau = \frac{V80}{V70} \times \frac{R42}{R54} \times \frac{Cc}{C0} \times \frac{1}{A \times f24} \times \sum_{i=0}^{n}(Bi \times 2^{i}) .$$

On veillera à utiliser, pour la génération des tensions de référence influençant la valeur du retard, un unique circuit ou des circuits de structure identiques. En d'autres termes, les tensions de référence sont générées soit sous la forme des tensions (externes) V27 et V57 issues d'un même circuit, soit sous la forme des tensions (internes) V72 et V80, par des circuits de même structure (par conception des sources de courant).

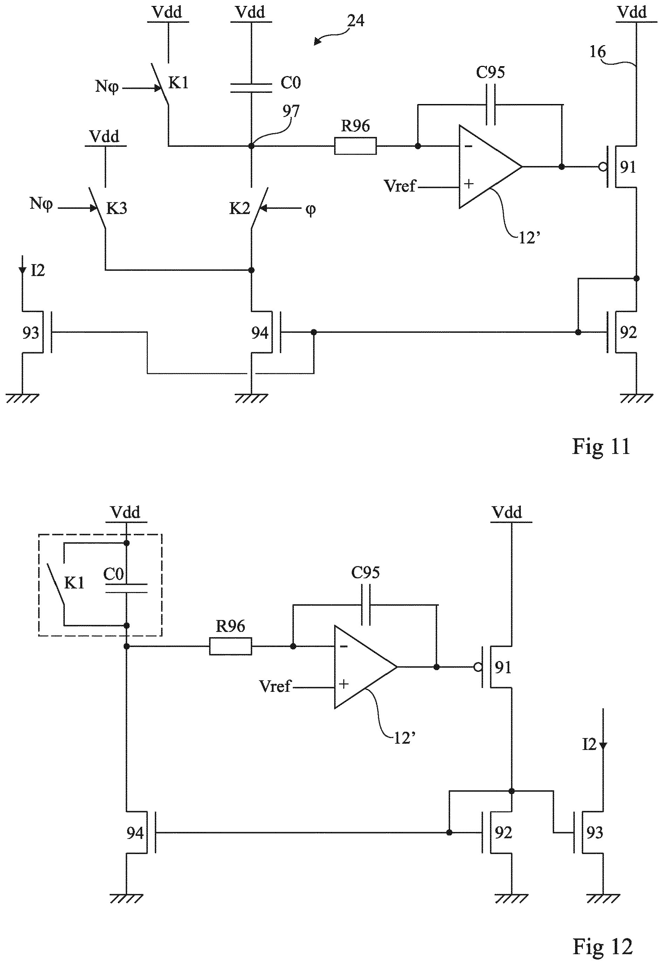

La figure 11 représente, de façon schématique et fonctionnelle, un autre mode de réalisation d'une source de courant.

Le mode de réalisation de la figure 11 représente un exemple de circuit de génération du courant I2.

Ce mode de réalisation reprend le principe de l'utilisation d'un amplificateur opérationnel comme en figure 4 ou 7, cet amplificateur 12' étant ici en outre monté en intégrateur pour réaliser une fonction de filtrage interne de boucle d'asservissement de la tension aux bornes de la résistance à capacité commutée à une tension de référence Vref. De plus, la figure 11 illustre le cas où la capacité C0 et l'interrupteur de réinitialisation K1 associé sont placés côté borne 16 de fourniture de la tension Vdd.

Dans l'exemple de la figure 11, la sortie de l'amplificateur 12' est reliée, de préférence connectée, à la grille d'un transistor PMOS 91 associé en série avec un transistor NMOS 92 entre la borne 16 et la masse. Le transistor 92 est monté en miroir sur un transistor NMOS 93 tirant le courant I2. La sortie de l'amplificateur 12' est rebouclée sur son entrée inverseuse par un condensateur C95, cette entrée inverseuse étant reliée, par une résistance R96, au noeud 97 entre l'interrupteur K1 en parallèle à la capacité commutée C0 et un interrupteur K2, lui-même relié à la masse par un transistor NMOS 94. L'entrée non-inverseuse de l'amplificateur 12' reçoit une tension de référence Vref (externe telle que la tension V27). Le transistor 94 est monté en miroir sur les transistors 92 et 93. En outre, le point milieu entre les interrupteurs K2 et 94 est relié à la borne 16 par un interrupteur K3 reliant, en position fermée, le transistor 94 à la tension Vdd. L'interrupteur K2 est commandé par un signal φ tandis que les interrupteurs K1 et K3 sont commandés par l'inverse Nφ du signal de commande de l'interrupteur K3. Le montage intégrateur permet d'atténuer les variations en sortie de l'amplificateur 12'.

La figure 12 représente, de façon schématique et fonctionnelle, encore un autre mode de réalisation d'une source de courant.

Le mode de réalisation de la figure 11 représente un exemple de circuit de génération du courant I2.

Le mode de réalisation de la figure 12 représente un schéma simplifié par rapport au mode de réalisation de la figure 11. On y retrouve les mêmes éléments à l'exception des interrupteurs K2 et K3, le transistor 94 étant directement connecté au noeud 97.

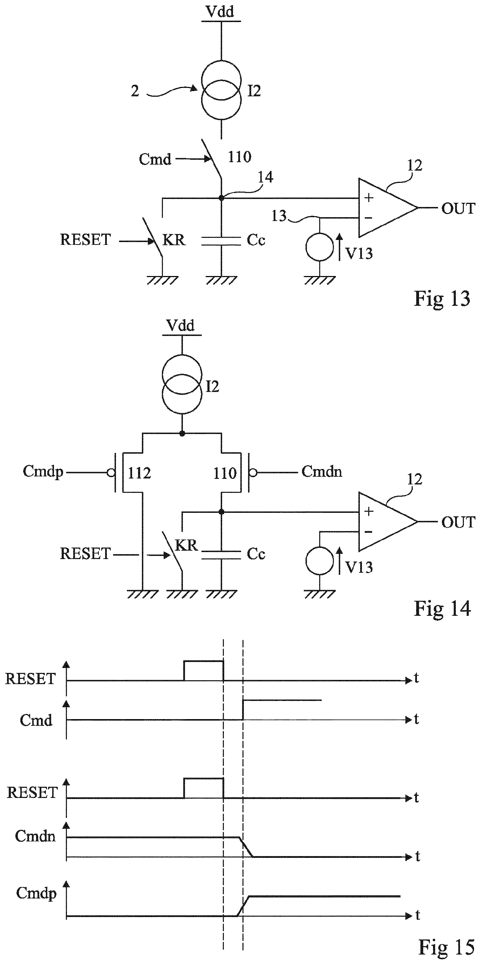

La figure 13 représente, de façon très schématique, un schéma de principe d'un circuit retardateur à rampe.

Ce schéma permet de présenter une possibilité de procédé de réinitialisation de la capacité d'intégration Cc.

Le schéma de la figure 13 reprend tous les éléments du circuit de la figure 1 et ajoute un interrupteur 110 entre la source de courant 2 (I2) et le noeud 14 (borne de la capacité Cc et entrée non-inverseuse de l'amplificateur 12), ici monté en comparateur).

L'interrupteur 110 est commandé par un signal Cmd et a pour rôle principal d'éviter qu'un courant I2 circule à travers le transistor de réinitialisation KR lorsque ce dernier est rendu conducteur pour réinitialiser la capacité Cc. En effet, la circulation d'un courant I2 à travers le transistor de réinitialisation KR pendant la phase de décharge induit une tension « résiduelle » aux bornes du transistor, donc de la capacité, en fin de réinitialisation. Cette tension résiduelle est susceptible de varier en fonction de la température, de la tension d'alimentation et est, de plus, fonction de la valeur du courant I2, ce qui peut être préjudiciable pour une utilisation du circuit retardateur dans laquelle le courant I2 est rendu variable pour changer la pente de charge du condensateur Cc.

La figure 14 représente, de façon schématique, un mode de réalisation d'un circuit retardateur tel que schématisé en figure 13.

Le mode de réalisation de la figure 14 constitue un schéma perfectionné du circuit retardateur de la figure 13.

Par rapport au circuit de la figure 13, un transistor PMOS 112 relie la source de courant 2 directement à la masse, l'interrupteur 110 étant ici symbolisé par un autre transistor PMOS. Les transistors 110 et 112 sont commandés par des signaux Cmdp et Cmdn inversés. L'utilisation d'un interrupteur « complémentaire » 112, dérivant le courant à la masse, permet de s'assurer que la source de courant I2 est pleinement fonctionnelle au moment où elle se trouve reliée à la capacité Cc, et permet des valeurs des tensions Cmdp et Cmdn plus réduites car c'est leur différence de potentiel qui importe pour l'activation d'une branche ou d'une autre et non leurs valeurs absolues. En pratique, il suffit de quelques centaines de millivolts de différence et non d'une pleine excursion de tension (0 - 1V), ce qui permet de commuter plus rapidement ces tensions de commande pour une meilleure précision du retard, notamment de son front de « démarrage ».

La figure 15 illustre, par des chronogrammes, un exemple de signaux de commande des circuits retardateurs des figures 13 et 14.

Les deux premiers chronogrammes illustrent le fonctionnement du schéma de la figure 13 tandis que les trois derniers chronogrammes illustrent le fonctionnement du schéma de la figure 14.

Comme il ressort de ces chronogrammes, les signaux Cmd (deuxième chronogramme) et les signaux Cmdn et Cmdp (quatrième et cinquième chronogrammes) sont retardés par rapport à la fin du créneau de réinitialisation de la capacité (signal RESET à l'état haut) afin d'assurer une réinitialisation complète de la capacité Cc, non perturbée par le courant I2. Dans le cas où le démarrage du délai est donné par le front descendant du signal de réinitialisation, on cherchera à minimiser ce décalage entre le front descendant du signal RESET et les fronts suivants des signaux de commande Cmd (ou Cmdn et Cmdp). En variante, le début du délai pourra correspondre au front d'activation des signaux de commande permettant au courant I2 de circuler et de charger la capacité Cc.

Un avantage des modes de réalisation décrits selon le premier aspect ci-dessus est que l'on obtient un retardateur programmable numériquement qui est stable en température et en tension et dont la programmation s'effectue dans une portion linaire de la rampe de tension générée.

Un autre avantage est que la combinaison de l'intégration analogique du courant de référence I2 pour obtenir la rampe de tension, et la programmation numérique du retard souhaité, apporte non seulement une résolution fine (qui dépend du nombre de bits du convertisseur numérique-analogique) mais également une grande plage de fonctionnement.

La détermination des différentes valeurs à donner aux composants du retardateur dépend de l'application. Ces valeurs peuvent être fixées par application des formules décrites, puis affinées empiriquement ou par des tests.

Divers modes de réalisation et variantes ont été décrits. Ces divers modes de réalisation et variantes sont combinables et d'autres variantes apparaitront à l'homme de l'art. En particulier, bien que l'on ait fait plus particulièrement référence à un générateur de retard programmable, les modes de réalisation décrits se transposent à un générateur de retard de valeur fixe (figée à la fabrication du circuit) et présentent alors les mêmes avantages en termes de stabilité en température et en tension d'alimentation. Il suffit en effet de prévoir, en guise de tension V13, une tension de référence fixe non réglable. En outre, la détermination des différentes valeurs et le dimensionnement des composants dépend de l'application et est à la portée de l'homme du métier à partir des indications fonctionnelles données ci-dessus.

**Revendications**

**1.** Circuit (1) de génération d'un retard, comportant :

un élément capacitif (Cc) d'intégration d'un premier courant (I2) fourni par une première source de courant (2) comportant un circuit (24) à capacité commutée (C0) ;
un dispositif d'asservissement de la tension aux bornes du circuit à capacité commutée à une première tension de référence (V27, V70) ;

un premier interrupteur (KR) de décharge de l'élément capacitif ;

un amplificateur opérationnel (12), monté en comparateur, dont une première entrée reçoit une tension (V14) de charge dudit élément capacitif (Cc), dont une deuxième entrée reçoit une deuxième tension de référence (V13), et dont une sortie fournit un signal (OUT) représentatif du retard généré,

de sorte que la première tension de référence et la tension de charge présentent des variations similaires suite à des variations de température ou de tension d'alimentation.

**2.** Circuit selon la revendication 1, dans lequel la deuxième tension de référence (V13) est générée par une première impédance (R42 ; R62, R64) alimentée par une deuxième source de courant (4) fournissant un deuxième courant (I4) proportionnel à un troisième courant (I5), le troisième courant (I5) étant généré par une troisième source de courant (5) comportant une deuxième impédance (R54) de même nature que la première impédance.

**3.** Circuit selon la revendication 2, dans lequel la deuxième source de courant comprend un convertisseur numérique-analogique (4) permettant de choisir parmi plusieurs coefficients de proportionnalité entre le deuxième courant (I4) et troisième courant (I5).

**4.** Circuit selon la revendication 3, dans lequel une valeur numérique appliquée au convertisseur programme le retard.

**5.** Circuit selon l'une quelconque des revendications 1 à 4, dans lequel les tensions de référence sont générées par un ou plusieurs circuits de structure identiques.

**6.** Circuit selon l'une quelconque des revendications 1 à 5, dans lequel la première source de courant (2) comporte au moins un premier transistor MOS en série avec ledit circuit à capacité commutée (C0), et un amplificateur monté en suiveur de commande dudit premier transistor à partir de la première tension de référence (V27).

**7.** Circuit selon la revendication 6, dans son rattachement à l'une quelconque des revendications 2 à 5, dans lequel la troisième source de courant (5) comporte au moins un deuxième transistor MOS en série avec ladite deuxième impédance (R54), et un amplificateur monté en suiveur de commande dudit deuxième transistor à partir d'une troisième tension de référence (V57).

**8.** Circuit selon la revendication 6, dans lequel la première tension de référence et la troisième tension de référence ont un même signe de coefficient de température.

**9.** Circuit selon la revendication 6 ou 7, dans lequel la première tension de référence et la troisième tension de référence sont égales.

**10.** Circuit selon l'une quelconque des revendications 1 à 5, dans lequel la première source de courant comporte un montage différentiel dont une branche comporte le circuit à capacité commutée (24), des transistors en miroir (76, 78) de chacune des branches ayant des rapports de surface différents l'un de l'autre.

**11.** Circuit selon la revendication 10, dans son rattachement à la revendication 2, dans lequel la troisième source de courant comporte un montage différentiel dont une branche comporte la deuxième impédance (R54), des transistors en miroir (86, 88) de chacune des branches ayant des rapports de surface différents l'un de l'autre.

**12.** Circuit selon l'une quelconque des revendications 1 à 11, dans lequel le circuit à capacité commutée (24) est commandé par un signal périodique (CT).

**13.** Circuit selon l'une quelconque des revendications 1 à 12, dans lequel l'amplificateur opérationnel (12') est monté en intégrateur (12') de la tension aux bornes du circuit à capacité commutée (C0).

**14.** Circuit selon l'une quelconque des revendications 1 à 13, comportant en outre un deuxième interrupteur (110) entre la première source de courant (2) et une première borne (14) de l'élément capacitif (Cc).

**15.** Circuit selon la revendication 14, comportant en outre un troisième interrupteur (112) entre la première source de courant (2) et une masse du circuit.

Fig 1

Fig 2A

Fig 2B

Fig 2C

Fig 3

Fig 4

Fig 5

Fig 6A

Fig 6B

Fig 7

Fig 8

Fig 9

Fig 10

Fig 11

Fig 12

Vdd

2 → I2

Cmd → 110

14

RESET → KR    Cc    13    V13

+
−    OUT    12

Fig 13

Vdd

I2

Cmdp —| 112    110 |— Cmdn

RESET → KR    Cc    V13

+
−    OUT    12

Fig 14

RESET _____⎍_____ t

Cmd _____ ‾‾‾‾‾ t

RESET _____⎍_____ t

Cmdn ‾‾‾‾‾‾‾‾_____ t

Cmdp _____/‾‾‾‾‾‾‾ t

Fig 15

Europäisches
Patentamt

European
Patent Office

Office européen
des brevets

# RAPPORT DE RECHERCHE EUROPEENNE

Numéro de la demande

EP 19 21 4959

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 525 586 B1 (AHMED ABDULLAH [CA] ET AL) 25 février 2003 (2003-02-25) * abrégé; figures 1,2,5,6b,6c * * colonne 1, ligne 47 - ligne 51 * * colonne 2, ligne 35 - colonne 6, ligne 62 * | 1-9,12, 14 | INV. H03K5/13 H03K5/00 |
| A | US 2012/212265 A1 (QUAN XIAOHONG [US] ET AL) 23 août 2012 (2012-08-23) * abrégé; figures 3a,3b,4,5,6 * * alinéas [0004], [0028], [0030], [0031], [0032], [0045] * | 1-15 | |
| A | US 2018/323696 A1 (GAMMIE DAVID [US]) 8 novembre 2018 (2018-11-08) * abrégé; figure 5 * | 1,14 | |
| A | FR 2 975 246 A1 (ST MICROELECTRONICS GRENOBLE 2 [FR]; ST MICROELECTRONICS SA [FR]) 16 novembre 2012 (2012-11-16) * abrégé; figures 3,4 * | 1,12 | DOMAINES TECHNIQUES RECHERCHES (IPC) |
| A | US 2010/026542 A1 (WANG CHUANYANG [US] ET AL) 4 février 2010 (2010-02-04) * abrégé; figures 1,5,6 * * alinéas [0002], [0049] - [0055], [0065], [0066] * | 1,5,6,12 | H03K |
| A | US 2009/268778 A1 (LEE WEN MING [TW]) 29 octobre 2009 (2009-10-29) * abrégé; figures 1,3 * * alinéas [0002], [0014], [0016] * | 1,5 | |

Le présent rapport a été établi pour toutes les revendications

| Lieu de la recherche | Date d'achèvement de la recherche | Examinateur |
|---|---|---|
| Munich | 5 février 2020 | Mesic, Maté |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 21 4959

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-02-2020

| Document brevet cité au rapport de recherche | | Date de publication | Membre(s) de la famille de brevet(s) | | Date de publication |
|---|---|---|---|---|---|
| US 6525586 | B1 | 25-02-2003 | AUCUN | | |
| US 2012212265 | A1 | 23-08-2012 | US | 2012212265 A1 | 23-08-2012 |
| | | | WO | 2012115880 A1 | 30-08-2012 |
| US 2018323696 | A1 | 08-11-2018 | CN | 110521097 A | 29-11-2019 |
| | | | DE | 112018002324 T5 | 09-01-2020 |
| | | | TW | 201843932 A | 16-12-2018 |
| | | | US | 2018323696 A1 | 08-11-2018 |
| | | | WO | 2018204158 A1 | 08-11-2018 |
| FR 2975246 | A1 | 16-11-2012 | AUCUN | | |
| US 2010026542 | A1 | 04-02-2010 | CN | 102113208 A | 29-06-2011 |
| | | | EP | 2321898 A1 | 18-05-2011 |
| | | | JP | 5144811 B2 | 13-02-2013 |
| | | | JP | 2011530246 A | 15-12-2011 |
| | | | KR | 20110051221 A | 17-05-2011 |
| | | | TW | 201014192 A | 01-04-2010 |
| | | | US | 2010026542 A1 | 04-02-2010 |
| | | | WO | 2010014993 A1 | 04-02-2010 |
| US 2009268778 | A1 | 29-10-2009 | TW | 200944985 A | 01-11-2009 |
| | | | US | 2009268778 A1 | 29-10-2009 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012212265 A
- US 20180323696 A
- US 20090268778 A
- US 20100026542 A
- FR 2975246 A